# EUROPÄISCHE PATENTSCHRIFT

(11) **EP 2 590 490 B1**
(45) Veröffentlichungstag und Bekanntmachung des Hinweises auf die Patenterteilung: **08.01.2014**
(21) Anmeldenummer: 11008719.4
(22) Anmeldetag: 02.11.2011
(51) Int. Cl.: G01R 31/02, H05K 7/14, B65D 88/74, G01R 31/12

(54) **Prüfcontainer**
Test container
Conteneur de vérification

(43) Veröffentlichungstag der Anmeldung: 08.05.2013
(73) Patentinhaber: ABB Technology AG, 8050 Zürich (CH)
(72) Erfinder: Steiger, Matthias, 06808 Bitterfeld-Wolfen OT Holzweißig (DE); Werle, Peter, 29664 Walsrode (DE); Szczechowski, Janusz, 04229 Leipzig (DE); Kouzmine, Oleg, 40217 Düsseldorf (DE); Kirschmann, Andreas, 06542 Allstedt OT Sotterhausen (DE)
(74) Vertreter: Partner, Lothar

(56) Entgegenhaltungen:
- EP-A1- 2 133 704
- US-A1- 2010 301 672

## Beschreibung

Die Erfindung betrifft einen Prüfcontainer, umfassend einen quaderähnlichen Container, darin angeordnete elektrische Komponenten eines Transformatorprüfsystems, welche im Prüfbetrieb eine jeweilige Wärmequelle darstellen und ein zugehöriges Kühlsystem mit wenigstens einem Wärmeübertrager. Solche Container sind zum Beispiel in EP 213 3704 oder US 2010 301672 offenbart.

Es ist allgemein bekannt, dass Hochspannungstransformatoren, beispielsweise in einem Spannungsbereich von 110kV oder 380kV und in einem Leistungsbereich von 100MVA und höher, sowohl zu Revisionszwecken als auch nach Abschluss von eventuellen Wartungs- oder Reparaturarbeiten aber auch direkt nach ihrer Fabrikation intensiv zu prüfen sind, um deren einwandfreie Funktion für den nächsten Betriebszeitraum sicher zu stellen, was oftmals eine Vielzahl an Jahren ist. Es sind sowohl stationäre als auch mobile Prüffelder im Einsatz. Letztere werden insbesondere für eine Vor- Ort- Prüfung von Transformatoren aufgebaut, danach abgebaut und zu einem nächsten Einsatzort transportiert. Auch wenn der Transport und Aufbau eines mobilen Prüffeldes zumeist mit einem sehr hohen Aufwand verbunden ist, so ist dieser dennoch zumeist geringer, als der Aufwand, einen Transformator mit einem Gewicht von beispielsweise 200t zu einem stationären Prüffeld zu transportieren. In vorteilhafter Weise ist zudem dann die Ausfallzeit eines in Prüfung befindlichen Transformators deutlich reduziert.

Hierbei kommen sowohl DC als auch AC Prüffelder zum Einsatz, mit welchen die entsprechenden Prüfbedingungen hergestellt werden können. Insbesondere AC Prüffelder müssen in der Lage sein, über einen längeren, oft mehrere Stunden andauernden, Zeitraum eine hohe elektrische Prüfleistung mit variabler Frequenz und variabler Spannung bereit zu stellen, beispielsweise für einen Dauerbelastungstest oder einen Kurzschlusstest. Hierbei haben sich aufgrund ihrer hohen Flexibilität rotierende Umformer bewährt, welche sich aufgrund des mechanischen Verschleißes aber als sehr wartungsintensiv erweisen. Zudem ist der Transport, Auf- und Abbau eines derartigen Umformers sehr arbeitsintensiv und es sind zusätzliche vibrationsdämpfende Maßnahmen für den Montageuntergrund vorzusehen.

Als nachteilig erweist sich bei den bestehenden AC Prüffeldsystemen also, dass diese einen hohen Aufwand für deren Transport, Auf- und Abbau erfordern und durch den typischerweise verwendeten rotierenden Umformer zudem sehr wartungsintensiv sind.

Ausgehend von diesem Stand der Technik ist es Aufgabe der Erfindung, ein Prüffeldsystem beziehungsweise Prüffeldsystemkomponenten für die Prüfung von Hochspannungstransformatoren zur Verfügung zu stellen, welche einen besonders einfachen Transport, Auf- und Abbau des Prüffeldsystems ermöglichen und einen rotierenden Umformer vermeiden.

Diese Aufgabe wird gelöst durch einen Prüfcontainer der eingangs genannten Art. Dieser ist dadurch gekennzeichnet, dass eine Bewegungsvorrichtung vorgesehen ist, mittels welcher der wenigstens eine Wärmeübertrager von einer Transportposition innerhalb des Containers in eine zumindest teilweise außerhalb des Containers befindliche Arbeitsposition bewegbar ist.

Die Grundidee der Erfindung beruht einerseits darin, ein Prüffeldsystem einerseits zumindest teilweise aus standardisierten Modulen aufzubauen, welche einfach zu transportieren sind und vor Ort beispielsweise durch entsprechende elektrische Steckverbindungen einfach zu einem kompletten Prüfsystem verschaltet werden können. Andererseits sind die jeweiligen Module möglichst elektrisch leistungsfähig auszugestalten, um so die Anzahl der Module und damit auch den Transport- und Montageaufwand eines kompletten Prüfsystems in vorteilhafter Weise zu reduzieren. Um den Transport eines derartigen Moduls besonders zu vereinfachen ist als Umhausung ein Container oder ein vergleichbarer quaderähnlicher Behälter vorgesehen, in welchem zumindest die Mehrzahl der Komponenten des Prüfsystems fest montiert ist und auch nach Aufstellung des Behälters vor Ort nicht neu angeordnet werden muss. Hierdurch ist auch der Aufbau vor Ort in vorteilhafter Weise vereinfacht.

Erfindungsgemäß sind anstelle eines rotierenden Umformers leistungselektronische Komponenten, insbesondere Wechsel- und Gleichrichter vorgesehen, mittels welcher eine Umformung der Versorgungsspannung, beispielsweise 6kV oder 10kV, in die gewünschte Frequenz oder Spannungshöhe erfolgt. Bedarfsweise ist für das erfindungsgemäße Prüfsystem auch ein Prüftransformator vorgesehen, um eine Spannungstransformation der Prüfspannung um einen höheren Faktor, beispielsweise in einem Bereich von 2 bis 20, zu ermöglichen.

Wechsel- beziehungsweise Gleichrichter sind an sich nicht neu und beispielsweise aus dem Gebiet der Hochspannungsgleichstromübertragung bekannt. Aufgrund der unvermeidbaren Umrichterverluste, welche bei Volllast je Umrichter beispielsweise im Bereich von 1 % bis 5% der jeweiligen Nennleistung liegen, ergibt sich jedoch insbesondere im Dauerbetrieb von derartigen Gleich- und/oder Wechselrichtern eine hohe Verlustleistung, beispielsweise bei einer Nennleistung von 5MVA und einem Wirkungsgrad von 95% eine dauerhaft abzuführende Verlustleistung von 250kW.

Insbesondere bei erfindungsgemäßer Anordnung der Umrichter in einem modulähnlichen Container stellt sich bei Betrieb des Prüfsystems das Problem der Abfuhr der anfallenden Wärmeleistung aus dem Container, weshalb ein Kühlsystem erforderlich ist. Ein Kühlsystem beansprucht jedoch ebenfalls Raum innerhalb des Containers beziehungsweise quaderähnlichen Behälters, wodurch die maximal innerhalb des Containers installierbare Wechselrichterleistung unvorteilhaft reduziert wird und bei vorgegebener installierter Leistung die Anzahl der benötigten Umrichtercontainer erhöht wird. Der Container ist in seinen Dimensionen nämlich nicht beliebig erweiterbar, vielmehr richten sich dessen Außenabmessungen vorzugsweise nach gängigen Transportprofilen, also insbesondere nach den Abmessungen eines Standard-Transportcontainers. Diese betragen in der Breite 2,438m, in der Höhe 2,591m und in der Länge 6,058m beziehungsweise 12,192m, wobei selbstverständlich auch andere gängige Profile möglich und sinnvoll sind.

Um sowohl eine möglichst hohe installierte Wechselrichterleistung innerhalb gegebener Containerabmessungen zu realisieren als auch ein Kühlsystem mit hierfür ausreichender Kühlleistung zur Verfügung zu stellen, ist erfindungsgemäß eine Bewegungsvorrichtung vorgesehen, mittels welcher der wenigstens eine Wärmeübertrager von einer Transportposition innerhalb des Containers in eine zumindest teilweise außerhalb des Containers befindliche Arbeitsposition bewegbar ist. Die Restriktionen an die Außenabmessungen des Containers beziehungsweise containerähnlichen Behälters sind nämlich nur im konkreten Falle eines Transportes des Containers relevant. Wenn dieser vor Ort aufgestellt worden ist, ist ein Überschreiten der Transportabmessungen ohne weiteres möglich.

Ein Kühlsystem umfasst wenigstens einen Wärmeübertrager, welcher die abzuführende Wärme eines durch das Innere des Wärmeübertragers fließenden Mediums, beispielsweise Luft oder eine Kühlflüssigkeit, an ein den Wärmeübertrager umgebendes zweites Medium abgibt, beispielsweise an die Umgebungsluft. Die Leistungsfähigkeit eines Wärmeübertragers ist umso höher, je größer die vom Wärmeübertrager bereit gestellte indirekte Kontaktfläche zwischen den beiden Medien ist. Durch das Anordnen des Wärmeübertragers in einer Transportposition innerhalb des Containers ist einerseits eine sehr platzsparende Anordnung gegeben, wohingegen in herausgefahrenem Zustand in einer Arbeitsposition in vorteilhafter Weise eine deutliche Vergrößerung der jeweiligen Kontaktflächen gegeben ist, so dass trotz kompakter Transportabmessungen dennoch eine hohe Leistungsfähigkeit des Wärmeübertragers gegeben ist.

Die innerhalb eines Prüfcontainers installierbare Nennleistung von Verlustwärme produzierenden elektrischen Komponenten, beispielsweise von Umrichtern, ist bei gegebenen äußeren Abmessungen des Containers damit in vorteilhafter Weise gesteigert.

Entsprechend einer besonders bevorzugten Ausgestaltungsform des erfindungsgemäßen Prüfcontainers umfasst das Kühlsystem einen geschlossenen Kühlkreislauf eines Kühlmediums, wobei der wenigstens eine Wärmeübertrager ein Kondensator ist und im Containerinneren wenigstens ein damit über den Kühlkreislauf verbundener Verdampfer vorgesehen ist. Das Kühlmedium entzieht der zu kühlenden Komponente, beispielsweise einem Wechselrichter, über einen Verdampfungsprozess im Verdampfer die abzuleitende Wärmeenergie und gibt diese über einen im Kondensator stattfindenden Kondensationsprozess an ein weiteres Medium wie die Umgebungsluft ab. Hierdurch wird die Effektivität des Kühlsystems in vorteilhafter Weise gesteigert. Zudem lässt sich ein Kondensator gezielt an einer punktuellen Wärmequelle anordnen, weshalb die Effektivität des Kühlsystems noch weiter gesteigert wird.

Einer weiteren Ausführungsvariante des erfindungsgemäßen Prüfcontainers folgend ist der Kühlkreislauf zwischen dem wenigstens einen bewegbaren Kondensator und dem wenigstens einen Verdampfer zumindest abschnittsweise durch eine flexible Schlauchleitung gebildet. Dies ermöglicht nämlich ein problemloses Herausbewegen des Verdampfers aus dem Prüfcontainer, ohne dass der geschlossene Kühlkreislauf in Mitleidenschaft gezogen wird. Selbstverständlich ist auch jede andere Art von flexiblen Leitungen geeignet, eine bewegbare Verbindung zwischen Verdampfer und Kondensator herzustellen.

Entsprechend einer weiteren Ausführungsvariante des erfindungsgemäßen Prüfcontainers sind im Containerinneren mehrere Verdampfer in direkter Nähe zu jeweiligen Wärmequellen vorgesehen. Durch eine derartige Verästelung des Kühlkreislaufes werden direkt die Wärmequellen, insbesondere die jeweiligen Umrichter gekühlt, weshalb sich entsprechend weniger Wärme direkt im Containerinneren ausbreiten kann. Die Anzahl an Umrichtern, also Gleich- und Wechselrichtern, richtet sich nach der gewünschten elektrischen Leistung beziehungsweise Spannung. So können innerhalb eines Prüfcontainers ohne weiteres beispielsweise 12 oder mehr gleichartige Umrichter vorgesehen sein, welche dann beispielsweise elektrisch parallel geschaltet sind.

Gemäß einer weiteren erfindungsgemäßen Variante des Prüfcontainers ist der wenigstens eine Wärmeübertrager oder auch Kondensator schubladenähnlich durch dafür vorgesehene Öffnungen aus einer Seitenwand des Containers heraus bewegbar. Hierzu sind beispielsweise beidseitig des vorzugsweise flach und mit rechteckigem Grundriss auszuführenden Kondensators teleskopartige Schienen angeordnet, welche bedarfsweise mittels einer Antriebsvorrichtung bewegbar sind. Eine derartige schubladenähnliche Bewegung ermöglicht nämlich einen besonders einfachen Positionswechsel von einer Transportposition des Wärmeübertragers in eine Arbeitsposition und zurück sowie das platzsparende parallele Anordnen mehrerer Wärmeübertrager in einer gemeinsamen Ebene. Einer weiteren Erfindungsvariante entsprechend sind mehrere Wärmeübertrager aus einer oder mehreren Seitenwänden des Containers heraus bewegbar. Dies ermöglicht unter anderem, in der jeweiligen Transportposition beispielsweise eine komplette Ebene innerhalb des Containers mit eingefahrenen Wärmeübertragern zu bedecken, welche dann in der jeweiligen Arbeitsposition komplett oder zumindest nahezu komplett ausgefahren ist.

Entsprechend einer weiteren Erfindungsvariante sind Mittel zur forcierten Um- oder Durchströmung des wenigstens einen Wärmeübertragers mit Umgebungsluft vorgesehen. Dies ist beispielsweise ein Ventilator oder ein sonstiges Gebläse, welches auf die äußere Oberfläche des wenigstens einen Wärmeübertragers oder auch Kondensators gerichtet ist. Dieses kann derart geregelt sein, dass dieses nur bei erhöhtem Kühlbedarf aktiviert wird. Die Kühlleistung wird hierdurch vorteilhaft gesteigert.

Entsprechend einer besonders bevorzugten Ausgestaltungsform des erfindungsgemäßen Prüfcontainers weist dieser die Abmessungen eines Standard- Transportcontainers auf und ist nach CSC zugelassen. Eine Zulassung nach CSC (International Convention for Save Containers) ermöglicht unter anderem die Anordnung des Containers in einer beliebigen Position eines Containerstapels auf einem Frachtschiff. Durch die Einhaltung der Abmessungen eines Standardcontainers steht eine Vielzahl an Verkehrsmitteln wie Bahn, Schiff oder LKW zur Verfügung, mit welchen ein problemloser Transport gewährleistet ist.

Gemäß einer weiteren bevorzugten Ausgestaltungsform des erfindungsgemäßen Prüfcontainers weist dieser eine innere Stützstruktur mit Hohlstreben auf, wobei zumindest einige der Hohlstreben mit zumindest einem Abschnitt ihres jeweiligen Innenraums einen Teil eines geschlossenen Kühlkreislaufes eines Kühlsystems für den Container bilden. Insbesondere bei der Rahmenkonstruktion sind typischerweise rechteckige Hohlrohrprofile vorgesehen, um die Stabilität des Containers zu gewährleisten. Ebenso sind im Bodenbereich zumeist parallele und quer zu den Seitenwänden verlaufende Hohlrohrprofile als Bodenverstärkung vorgesehen, welche beispielsweise die Gewichtslast von im Container angeordneten Komponenten abtragen. Erfindungsgemäß ist vorgesehen, zumindest einen Teil der Hohlraumprofile mit ihren jeweiligen Innenräumen strömungstechnisch als Teil eines geschlossenen Kühlkreislaufes des Containers miteinander zu verbinden.

So kann in vorteilhafter Weise ein geschlossener Kühlkreislauf zwischen einem oder mehreren Verdampfern und einem oder mehreren Kondensatoren in einen bereits vorhandenen rohrähnlichen Hohlraum integriert werden, ohne dass der zur Verfügung stehende Innenraum des Containers dadurch reduziert wird. Dieser kann dann in vollem Umfang mit elektrischen oder anderen für ein Prüfsystem benötigten Komponenten genutzt werden, beispielsweise durch Umrichter.

Entsprechend einer weiteren Erfindungsvariante ist zumindest durch einen Teil der Hohlstreben ein Verdampfer eines Kühlsystems für den Container gebildet, beispielsweise der Innenraum von mäanderförmig in Reihe geschalteten Bodenhohlraumprofilen, wobei hierzu bedarfsweise entsprechende Verdichter und Pumpmittel notwendig sind. Somit kann beispielsweise der Containerboden komplett mit einer Kühlfunktion ausgestattet werden, ohne dass zusätzlicher Raumbedarf entsteht.

Es ist gemäß einer weiteren Erfindungsvariante auch möglich, dass im Inneren von wenigstens einer Hohlstrebe ein separater schlauch- oder rohrähnlicher Hohlkörper geführt ist, durch welchen ein Abschnitt des geschlossenen Kühlkreislaufes gebildet ist. Hier wird der Innenraum der Hohlstreben letztendlich nicht direkt als Rohrleitung genutzt, sondern lediglich als ein Führungskanal für eine darin geführte weitere Schlauch- oder Rohrleitung. Der Effekt der Platzersparnis ist derselbe, es ist jedoch ein erhöhtes Maß an Sicherheit gegenüber einer eventuellen Leckage des Kühlkreislaufes gewährleistet, weil die innere Leitung durch das Hohlstrebenprofil entsprechend gegen mechanische Beanspruchungen geschützt ist.

Die erfindungsgemäße Aufgabe ist auch gelöst durch ein Prüffeldsystemen für Leistungstransformatoren, wobei dieses modular aufgebaut ist und wenigstens einen erfindungsgemäßen Prüfcontainer mit entsprechenden Leistungstransformatorprüfvorrichtungen umfasst. Wie eingangs erwähnt ermöglicht der modulare Aufbau, vorzugsweise unter Verwendung von Containern oder quaderähnlichen Behältern als Gehäuse, einen einfachen Transport und problemlosen Aufbau vor Ort, insbesondere weil die Prüfkomponenten zumindest überwiegend bereits in einer festen Position innerhalb des Containers angeordnet sind. Die Modularität ermöglicht zudem ein bedarfsweises elektrisches Zusammenschalten von mehreren standardisierten Komponenten, wie beispielsweise Umrichtermodulen, zu einem Prüfsystem. So ist beispielsweise die Leistung eines Prüffeldes durch Implementierung eines weiteren Umrichtermoduls entsprechend einfach steigerbar. Durch Verwendung eines erfindungsgemäßen Prüfcontainers mit platzsparendem Kühlsystem und heraus bewegbarem Wärmeübertrager ist die realisierbare Nennleistung eines Prüfmoduls in vorteilhafter Weise gesteigert.

Es lassen sich auch beliebige weitere - vorzugsweise containerähnlich ausgeführte - Prüfmodule miteinander zu einem individuellen Prüfsystem verschalten. Ein weiteres derartiges Modul ist beispielsweise ein Prüftransformator zur Umspannung einer erzeugten Prüfspannung, welcher ebenfalls in einem Container mit entsprechenden Lastauflagepunkten angeordnet ist. Lastauflagepunkte sind bei Containern an den jeweiligen Eckpunkten vorgesehen, nämlich vier unten und vier oben. Durch derartig definierte Lastauflagepunkte ist ein beliebiges Stapeln der standardisierten Container beispielsweise beim Schiffstransport ermöglicht. Es ist auch möglich, einen Container direkt als Ölkessel für einen darin angeordneten Transformator zu verwenden. Bei einer derartigen Variante kann der Transport des Transformators im Container ohne Ölfüllung erfolgen, wobei der als Ölkessel dienende Container dann vor Ort mit Öl gefüllt wird. Als zweckmäßig erweist es sich auch, eventuelle Ausleitungen aus dem Container beim Transport zu entfernen und erst vor Ort anzubauen.

Als besonders vorteilhaft erweist sich für ein Prüffeldsystemen ein erfindungsgemäßer Prüfcontainer mit besonders platzsparendem Kühlsystem für die Anordnung von Umrichtern, weil diese aufgrund der relativ hohen Umrichterverluste einen besonders hohen Kühlbedarf aufweisen. Selbstverständlich lassen sich in einem erfindungsgemäßen Prüfcontainer aber auch andere im Prüfbetrieb Abwärme produzierende Komponenten eines Prüfsystems anordnen.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: einen ersten exemplarischen Prüfcontainer in Arbeitsposition,
- Fig. 2: einen zweiten exemplarischen Prüfcontainer in Transportstellung,
- Fig. 3: den Bodenbereich von einem dritten quaderähnlichen Container mit Hohlstreben,
- Fig. 4: einen dritten exemplarischen Prüfcontainer in Transportstellung,
- Fig. 5: einen exemplarischen Wechselrichterschrank und
- Fig. 6: einen exemplarischen geschlossenen Kühlkreislauf mit Verdampfer und Kondensator.

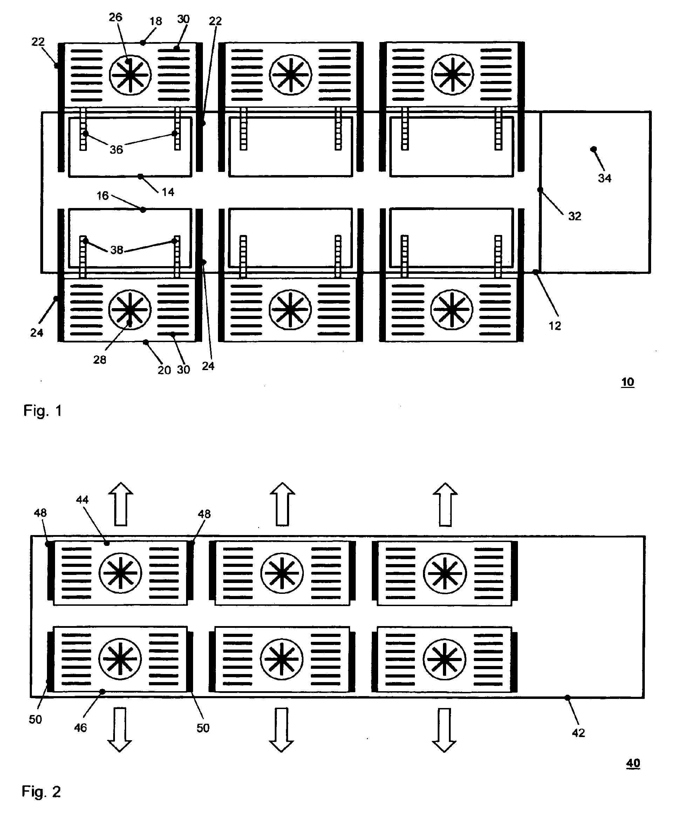

Fig. 1 zeigt einen ersten exemplarischen Prüfcontainer 10 mit insgesamt sechs heraus bewegten Wärmeübertragern 18, 20 in Arbeitsposition. Die Wärmeübertrager 18, 20 sind als Kondensatoren ausgebildet und Teil eines geschlossenen Kühlkreislaufes mit Verdampfern, welche in dieser Zeichnung nicht gezeigt sind und als in Wechselrichterschränken 14, 16 angeordnet anzunehmen sind. Der geschlossene Kühlkreislauf zwischen den jeweiligen Kondensatoren 18, 20 und den Verdampfern ist zumindest teilweise durch flexible Schlauchleitungen 36, 38 gebildet, welche ein Heraus-und Hereinbewegen der Wärmeübertrager ermöglichen, ohne dass der Kühlkreislauf dadurch beeinträchtigt wird. Die Wärmeübertrager 18, 20 sind als flache Quader ausgeführt und mittels teleskopschienenähnlicher Bewegungsvorrichtungen 22, 24 schubladenähnlich aus den Seitenwänden des Prüfcontainers 10 heraus bewegbar. Gegebenenfalls ist hierfür auch eine jeweilige Antriebsvorrichtung vorgesehen. Hierdurch ist im eingefahrenen Zustand eine platzsparende Anordnung der Wärmetauscher 18, 20 im Inneren des Prüfcontainers 10 ermöglicht und im ausgefahrenen Zustand eine aufgrund einer erhöhten Kontaktfläche mit der Umgebungsluft deutlich erhöhte Kühlleistung. Zur weiteren Erhöhung der Kühlleistung sind jeweilige Ventilatoren 26, 28 vorgesehen, welche für eine forcierte Umströmung der Wärmetauscher 18, 20 beziehungsweise der Kondensatoren sorgen. Demselben Zweck dienen Kühlrippen 30, welche an der Oberfläche der Wärmetauscher 18, 20 angebracht sind und vorzugsweise aus einem Metall gefertigt sind, welches über gute Wärmeleiteigenschaften verfügt, beispielsweise Aluminium.

Die äußere Begrenzung des Prüfcontainers 10 ist durch einen quaderähnlichen Container 12 gebildet, beispielsweise einen nach CSC zugelassenen 40 Fuß Container. Im rechten Teil des Containers 12 ist abgetrennt von einer Trennwand 32 ein Kontrollraum 34 vorgesehen, in welchem beispielsweise Steuerrechner für das Prüfsystem untergebracht sind. Es ist aber durchaus möglich, diesen Raum auch für weitere Wechselrichterschränke 14, 16 oder andere elektrische Komponenten zu nutzen. Der Vorteil eines erfindungsgemäßen Prüfcontainers 10 erschließt sich insbesondere bei der Anordnung von elektrischen Komponenten mit hohem Anfall an Verlustwärme, wie in diesem Bespiel von Umrichtern.

Fig. 2 zeigt einen zweiten exemplarischen Prüfcontainer 40 in Transportstellung. Dieser entspricht weitestgehend dem ersten Prüfcontainer 10. In einem quaderähnlichen Container 42 sind sechs Wechselrichterschränke angeordnet, welche durch jeweilige eingefahrene Wärmeübertrager 44, 46 verdeckt sind. Diese sind mittels teleskopschienenähnlicher Bewegungsvorrichtungen 48, 50 durch nicht gezeigte Containeröffnungen aus diesem heraus bewegbar. In der gezeigten Transportstellung ist der Prüfcontainer 40 problemlos mittels Schiff, LKW oder Bahn zu seinem Bestimmungsort transportierbar, wo er dann zusammen mit weiteren vorzugsweise ebenfalls in Containern angeordneten Prüfsystemmodulen zu einem Prüfsystem verschaltbar ist.

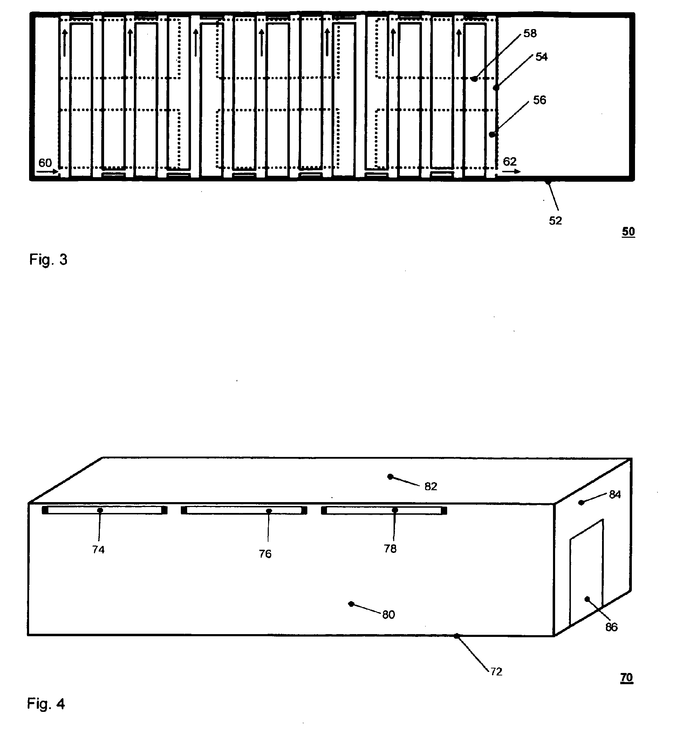

Fig. 3 zeigt den Bodenbereich 50 von einem dritten quaderähnlichen Container mit parallel angeordneten Hohlstreben 54 als Bodenverstärkung. Der Bodenbereich 50 ist von einer Rahmenstruktur 52 umschlossen, welche aus rechteckförmigen Hohlprofilen gebildet ist, beispielsweise aus Stahl. Eine derartige Bodenstruktur ist für Container, welche standardmäßig beispielsweise für ein Gesamtgewicht von maximal 30,48t zugelassen sind, üblich. In der Fig. sind die parallelen Hohlstreben 54, welche beispielsweise einen Querschnitt von 8cm x 8cm aufweisen, mit ihren inneren Hohlräumen 56 über zusätzliche Querverbindungen zu einer rohrartigen serpentinenähnlichen Struktur verbunden, welche dafür geeignet ist, von einem Kühlmittel durchströmt zu werden. Auf diese Weise ist es möglich, zumindest einen Teil eines Kühlmittelkreislaufes durch den Container zu führen, ohne dass zusätzlicher Raumbedarf entsteht. Der Kühlmediumzufluss in die serpentinenähnliche Struktur ist mit der Bezugsziffer 1 angedeutet, der Abfluss mit der Bezugsziffer 62. Es ist auch möglich, den Kühlmittelkreislauf mit gesondertem Vor- und Rücklauf auszuführen, also letztendlich zwei serpentinenähnliche Strukturen mit jeweils jeder zweiten Hohlstrebe zu bilden.

Neben ihrer erfindungsgemäßen Zusatzfunktion mit ihrem jeweiligen Innenraum 56 einen Teil eines Kühlkreislaufes des Containers zu bilden erfüllen die Hohlstreben auch die Aufgabe, die Last von im Container angeordneten Komponenten 58 abzutragen, in diesem Beispiel gestrichelt angedeutete Wechselrichterschränke. Durch die direkte Nähe zu der serpentinenähnlichen Struktur, in welcher ein Kühlmedium des geschlossenen Kühlkreislaufes geführt ist, ist ein Anschluss eines in einem jeweils in den Wechselrichterschränken angeordneten Verdampfers problemlos möglich, so dass die Verlustwärme direkt an der Wärmequelle, nämlich den im jeweiligen Wechselrichterschrank 58 angeordneten Umrichtern, abtransportiert werden kann.

Fig. 4 zeigt einen dritten exemplarischen Prüfcontainer 70 in Transportstellung, also mit nicht gezeigten eingefahrenen Wärmeübertragern. Der Prüfcontainer umfasst in dieser Ansicht im Wesentlichen einen quaderähnlichen Container 72, von welchem eine Seitenwand 80, ein Dach 82 und eine Stirnwand 84 sichtbar ist, welcher eine Zugangstür 86 in einen nicht gezeigten Kontrollraum eingefasst ist. Im oberen Bereich der Seitenwand 80 sind drei verschließbare Öffnungen 74, 76, 78 angedeutet, durch welche jeweilige Wärmeübertrager beziehungsweise Kondensatoren eines Kühlsystems aus dem Container 72 heraus bewegt werden können.

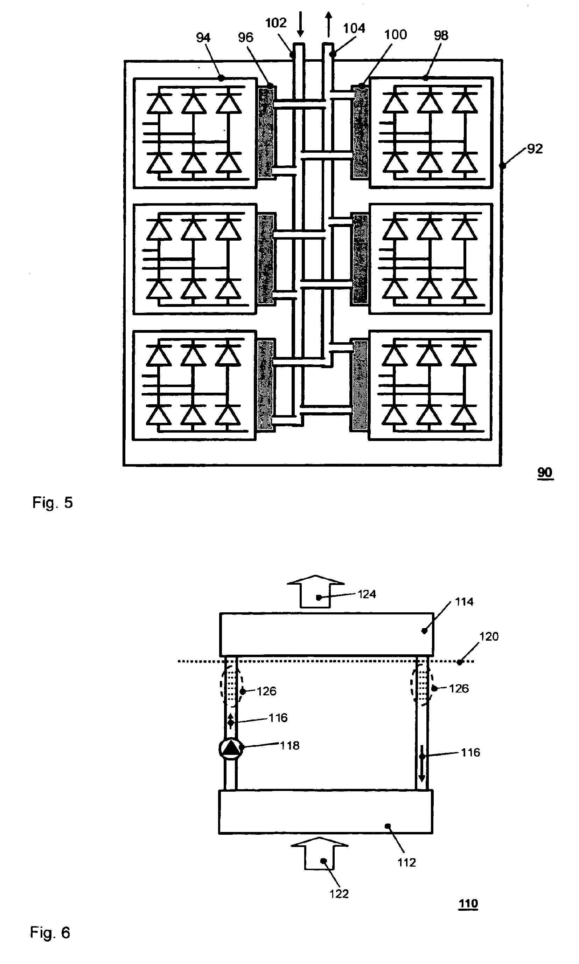

Fig. 5 zeigt einen exemplarischen Wechselrichterschrank 90 in einer Prinzipskizze. In einer schrankähnlichen Umhausung 92 angeordnet sind mehrere elektrisch miteinander verschaltete Wechselrichtermodule 94, 98, welchen jeweils direkt ein jeweiliger Verdampfer 96, 100 eines geschlossenen Kühlsystems zugeordnet ist. Die Zu- beziehungsweise Abführung von Mühlmittel erfolgt über einen jeweiligen Kühlmittelzufluss 102 beziehungsweise Kühlmittelabfluss 104, welche ihrerseits mit einem nicht gezeigten Kondensator verbunden sind. Diese Anordnung ermöglicht in vorteilhafter Weise ein direktes Kühlen der Wärme erzeugenden Komponenten 94, 98.

Fig. 6 zeigt einen exemplarischen geschlossenen Kühlkreislauf 110 mit Verdampfer 112 und Kondensator 114, welche abschnittsweise mittels zumindest abschnittsweise flexibler Leitungen 126 miteinander verbunden sind. Der Verdampfer 112 nimmt durch Verdampfung eines in ihm befindlichen Kühlmittels Wärmeenergie 122, welche beispielsweise in einem Wechselrichter entsteht, auf. Das Kühlmittel fließt dabei in der mit den Pfeilen 116 angedeuteten Flussrichtung zum Kondensator 114 und gibt darüber Wärmeenergie 124 an die Umgebung ab. Verdampfer 112 und Kondensator 114 sind durch eine Containerwand 120 getrennt, so dass der Kondensator also gerade als in einer außerhalb des Containers anzunehmenden Arbeitsposition befindlich ist. Um das Kühlmittel im Kühlmittelkreislauf in Umlauf zu halten ist eine Pumpe 118 vorgesehen.

### Bezugszeichenliste

- 10: erster exemplarischer Prüfcontainer in Arbeitsposition
- 12: erster quaderähnlicher Container
- 14: erste elektrische Komponente (Wechselrichterschrank)
- 16: zweite elektrische Komponente (Wechselrichterschrank)
- 18: erster Wärmeübertrager (Kondensator) in Arbeitsposition
- 20: zweiter Wärmeübertrager (Kondensator) in Arbeitsposition
- 22: Bewegungsvorrichtung für ersten Wärmeübertrager
- 24: Bewegungsvorrichtung für zweiten Wärmeübertrager
- 26: Ventilator für ersten Wärmeübertrager
- 28: Ventilator für zweiten Wärmeübertrager
- 30: Kühlrippe
- 32: Trennwand
- 34: Kontrollraum
- 36: erste flexible Schlauchverbindung
- 38: zweite flexible Schlauchverbindung
- 40: zweiter exemplarischer Prüfcontainer in Transportstellung
- 42: zweiter quaderähnlicher Container
- 44: erster Wärmeübertrager (Kondensator) in Transportposition
- 46: erster Wärmeübertrager (Kondensator) in Transportposition
- 48: Bewegungsvorrichtung für ersten Wärmeübertrager
- 49: Bewegungsvorrichtung für zweiten Wärmeübertrager
- 50: Bodenbereich von drittem quaderähnlichen Container mit Hohlstreben
- 52: Rahmenstruktur
- 54: Hohlstrebe
- 56: Innenraum von Hohlstrebe
- 58: im Container angeordnete Komponente
- 60: Kühlmediumzufluss
- 62: Kühlmediumabfluss
- 70: dritter exemplarischer Prüfcontainer in Transportstellung
- 72: vierter quaderähnlicher Container
- 74: erste Öffnung für heraus bewegbaren ersten Wärmeübertrager
- 76: zweite Öffnung für heraus bewegbaren zweiten Wärmeübertrager
- 78: dritte Öffnung für heraus bewegbaren dritten Wärmeübertrager
- 80: Seitenwand von Container
- 82: Dach von Container
- 84: Stirnwand von Container
- 86: Tür
- 90: exemplarischer Wechselrichterschrank
- 92: Umhausung
- 94: erstes exemplarisches Wechselrichtermodul
- 96: Verdampfer für erstes Wechselrichtermodul
- 98: zweites exemplarisches Wechselrichtermodul
- 100: Verdampfer für zweites Wechselrichtermodul
- 102: Kühlmediumzufluss
- 104: Kühlmediumabfluss
- 110: geschlossener Kühlkreislauf mit Verdampfer und Kondensator
- 112: Verdampfer
- 114: Kondensator
- 116: Flussrichtung von Kühlmedium
- 118: Pumpe
- 120: Containerwand
- 122: Wärmeeintrag
- 124: Wärmeaustrag
- 126: abschnittsweise flexible Schlauchleitung

## Patentansprüche

1. Prüfcontainer (10, 40, 70), umfassend
- einen quaderähnlichen Container (12, 42, 72),
- darin angeordnete elektrische Komponenten (14, 16, 90, 94, 96) eines Transformatorprüfsystems, welche im Prüfbetrieb eine jeweilige Wärmequelle darstellen
- und ein Kühlsystem mit wenigstens einem Wärmeübertrager (18, 20, 44, 46, 114)
**dadurch gekennzeichnet,**
**dass** eine Bewegungsvorrichtung (22, 24, 48, 49) vorgesehen ist, mittels welcher der wenigstens eine Wärmeübertrager (18, 20, 44, 46, 114) von einer Transportposition innerhalb des Containers (12, 42, 72) in eine zumindest teilweise außerhalb des Containers (12, 42, 72) befindliche Arbeitsposition bewegbar ist.

2. Prüfcontainer nach Anspruch 1, **dadurch gekennzeichnet, dass** das Kühlsystem einen geschlossenen Kühlkreislauf (110) eines Kühlmediums umfasst, wobei der wenigstens eine Wärmeübertrager ein Kondensator (114) ist und im Containerinneren wenigstens ein damit über den Kühlkreislauf (110) verbundener Verdampfer (112) vorgesehen ist.

3. Prüfcontainer nach Anspruch 2, **dadurch gekennzeichnet, dass** der Kühlkreislauf zwischen dem wenigstens einen bewegbaren Kondensator (114) und dem wenigstens einen Verdampfer (112) zumindest abschnittsweise durch eine flexible Schlauchleitung (36, 38, 126) gebildet ist.

4. Prüfcontainer nach einem der Ansprüche 2 oder 3, **dadurch gekennzeichnet, dass** im Containerinneren mehrere Verdampfer (96, 100, 112) in direkter Nähe zu jeweiligen Wärmequellen (94, 98) vorgesehen sind.

5. Prüfcontainer nach einem der vorherigen Ansprüche, **dadurch gekennzeichnet, dass** der wenigstens eine Wärmeübertrager (18, 20, 44, 46, 114) schubladenähnlich durch dafür vorgesehene Öffnungen (74, 76, 78) aus einer Seitenwand (80, 82, 84) des Containers (12, 42, 72) heraus bewegbar ist.

6. Prüfcontainer nach einem der vorherigen Ansprüche, **dadurch gekennzeichnet, dass** mehrere Wärmeübertrager (12, 42, 72) aus einer oder mehreren Seitenwänden (80, 82, 84) des Containers (12, 42, 72) heraus bewegbar sind.

7. Prüfcontainer nach einem der vorherigen Ansprüche, **dadurch gekennzeichnet, dass** Mittel (26, 28) zur forcierten Um- oder Durchströmung des wenigstens einen Wärmeübertragers (18, 20, 44, 46, 114) mit Umgebungsluft vorgesehen sind.

8. Prüfcontainer nach einem der vorherigen Ansprüche, **dadurch gekennzeichnet, dass** der quaderähnliche Container (12, 42, 72) die Abmessungen eines Standard-Transportcontainers aufweist und nach CSC zugelassen ist.

9. Prüfcontainer nach einem der vorherigen Ansprüche, **dadurch gekennzeichnet, dass** der quaderähnlichen Container (12, 42, 72) eine innere Stützstruktur mit Hohlstreben (54) aufweist und dass zumindest einige der Hohlstreben (54) mit zumindest einem Abschnitt ihres jeweiligen Innenraums (56) einen Teil eines geschlossenen Kühlkreislaufes (110) eines Kühlsystems für den Container (12, 42, 72) bilden.

10. Prüfcontainer nach Anspruch 9, **dadurch gekennzeichnet, dass** am Containerboden mehrere vorzugsweise parallel angeordnete Hohlstreben (54) angeordnet sind (50), welche dafür vorgesehen sind, die Gewichtslast von im Container (12, 42, 72) angeordneten Komponenten (14, 16, 58, 90) abzutragen und welche mit ihren jeweiligen Innenräumen (56) strömungstechnisch als Teil des geschlossenen Kühlkreislaufes (110) miteinander verbunden sind.

11. Prüfcontainer nach einem der Ansprüche 9 oder 10, **dadurch gekennzeichnet, dass** durch zumindest einen Teil der Hohlstreben (54) ein Verdampfer (112) eines Kühlsystems (110) für den Container (12, 42, 72) gebildet ist.

12. Prüfcontainer nach einem der Ansprüche 9 bis 11, **dadurch gekennzeichnet, dass** im Inneren (56) von wenigstens einer Hohlstrebe (54) ein separater schlauch- oder rohrähnlicher Hohlkörper (36, 38, 126) geführt ist, durch welchen ein Abschnitt des geschlossenen Kühlkreislaufes (110) gebildet ist.

13. Prüffeldsystemen für Leistungstransformatoren, **dadurch gekennzeichnet, dass** dieses modular aufgebaut ist und wenigstens einen Prüfcontainer nach einem der Ansprüche 1 bis 12 mit entsprechenden Leistungstransformatorprüfvorrichtungen umfasst.

14. Prüffeldsystemen für Leistungstransformatoren nach Anspruch 13, **dadurch gekennzeichnet, dass** durch die in wenigstens einem quaderähnlichen Container (12, 42, 72) angeordneten elektrischen Komponenten ein Wechselrichter für Prüfzwecke gebildet ist.

## Claims

1. Testing container (10, 40, 70), comprising
- a cuboidal container (12, 42, 72),
- electrical components (14, 16, 90, 94, 96) of a transformer testing system contained therein, representing a respective heat source in the test,
- and a cooling system comprising at least one heat exchanger (18, 20, 44, 46, 114),
**characterized**
**in that** a movement device (22, 24, 48, 49) is provided, by means of which the at least one heat exchanger (18, 20, 44, 46, 114) can be moved from a transporting position within the container (12, 42, 72) into a working position at least partially located outside the container (12, 42, 72).

2. Testing container according to Claim 2, **characterized in that** the cooling system comprises a closed cooling circuit (110) of a cooling medium, the at least one heat exchanger being a condenser (114) and at least one evaporator (112) connected thereto via the cooling circuit (110) being provided in the interior of the container.

3. Testing container according to Claim 2, **characterized in that** the cooling circuit between the at least one movable condenser (114) and the at least one evaporator (112) is formed at least in certain portions by a flexible hose line (36, 38, 126).

4. Testing container according to either of Claims 2 and 3, **characterized in that** multiple evaporators (96, 100, 112) are provided in the interior of the container in the direct vicinity of the respective heat sources (94, 98).

5. Testing container according to one of the preceding claims, **characterized in that** the at least one heat exchanger (18, 20, 44, 46, 114) can be moved out in the manner of a drawer from a side wall (80, 82, 84) of the container (12, 42, 72) through openings (74, 76, 78) provided for this.

6. Testing container according to one of the preceding claims, **characterized in that** multiple heat exchangers (18, 20, 44, 46, 114) can be moved out from one or more side walls (80, 82, 84) of the container (12, 42, 72).

7. Testing container according to one of the preceding claims, **characterized in that** means (26, 28) for the forced flow of ambient air around or through the at least one heat exchanger (18, 20, 44, 46, 114) are provided.

8. Testing container according to one of the preceding claims, **characterized in that** the cuboidal container (12, 42, 72) has the dimensions of a standard transport container and is approved in accordance with CSC.

9. Testing container according to one of the preceding claims, **characterized in that** the cuboidal container (12, 42, 72) has an inner supporting structure with hollow struts (54) and **in that** at least some of the hollow struts (54) form with at least a portion of their respective interior space (56) a part of a closed cooling circuit (110) of a cooling system for the container (12, 42, 72).

10. Testing container according to Claim 9, **characterized in that** multiple hollow struts (54), preferably arranged in parallel, which are intended for bearing the load of the weight of components (14, 16, 58, 90) arranged in the container (12, 42, 72) and are connected to one another in terms of flow by their respective interior spaces (56) as part of the closed cooling circuit (110), are arranged on the bottom of the container (50).

11. Testing container according to either of Claims 9 and 10, **characterized in that** an evaporator (112) of a cooling system (110) for the container (12, 42, 72) is formed by at least some of the hollow struts (54).

12. Testing container according to one of Claims 9 to 11, **characterized in that** a separate hose- or tubelike hollow body (36, 38, 126), by which a portion of the closed cooling circuit (110) is formed, is made to extend in the interior (56) of at least one hollow strut (54).

13. Test bay system for power transformers, **characterized in that** it is of a modular construction and comprises at least one testing container according to one of Claims 1 to 12 with corresponding power transformer testing devices.

14. Test bay system for power transformers according to Claim 13, **characterized in that** a power inverter for testing purposes is formed by the electrical components arranged in at least one cuboidal container (12, 42, 72).

## Revendications

1. Conteneur d'essai (10, 40, 70), comprenant
- un conteneur quadrangulaire (12, 42, 72),
- des composants électriques (14, 16, 90, 94, 96) d'un système d'essai de transformateur disposés dans celui-ci, lesquels constituent, en mode d'essai, une source de chaleur respective,
- et un système de refroidissement comprenant au moins un échangeur de chaleur (18, 20, 44, 46, 114),
**caractérisé en ce**
**qu'**un dispositif de déplacement (22, 24, 48, 49) est prévu, au moyen duquel l'au moins un échangeur de chaleur (18, 20, 44, 46, 114) peut être déplacé depuis une position de transport à l'intérieur du conteneur (12, 42, 72) jusqu'à une position de travail se trouvant au moins en partie à l'extérieur du conteneur (12, 42, 72).

2. Conteneur d'essai selon la revendication 1, **caractérisé en ce que** le système de refroidissement comprend un circuit de refroidissement fermé (110) d'un milieu de refroidissement, l'au moins un échangeur de chaleur étant un condenseur (114) et à l'intérieur du conteneur étant prévu au moins un évaporateur (112) connecté à celui-ci par le biais du circuit de refroidissement (110).

3. Conteneur d'essai selon la revendication 2, **caractérisé en ce que** le circuit de refroidissement entre l'au moins un condenseur mobile (114) et l'au moins un évaporateur (112) est formé au moins en partie par une conduite tubulaire flexible (36, 38, 126).

4. Conteneur d'essai selon l'une quelconque des revendications 2 ou 3, **caractérisé en ce que** plusieurs évaporateurs (96, 100, 112) sont prévus à proximité immédiate des sources de chaleur respectives (94, 98) à l'intérieur du conteneur.

5. Conteneur d'essai selon l'une quelconque des revendications précédentes, **caractérisé en ce que** l'au moins un échangeur de chaleur (18, 20, 44, 46, 114) peut être déplacé à la manière d'un tiroir par des ouvertures prévues à cet effet (74, 76, 78) hors d'une paroi latérale (80, 82, 84) du conteneur (12, 42, 72).

6. Conteneur d'essai selon l'une quelconque des revendications précédentes, **caractérisé en ce que** plusieurs échangeurs de chaleur (18, 20, 44, 46, 114) peuvent être déplacés hors d'une ou plusieurs parois latérales (80, 82, 84) du conteneur (12, 42, 72).

7. Conteneur d'essai selon l'une quelconque des revendications précédentes, **caractérisé en ce que** des moyens (26, 28) sont prévus pour faire circuler ou traverser de l'air ambiant de manière forcée autour ou à travers de l'au moins un échangeur de chaleur (18, 20, 44, 46, 114).

8. Conteneur d'essai selon l'une quelconque des revendications précédentes, **caractérisé en ce que** le conteneur quadrangulaire (12, 42, 72) présente les dimensions d'un conteneur de transport standard et est agréé conformément à la CSC.

9. Conteneur d'essai selon l'une quelconque des revendications précédentes, **caractérisé en ce que** le conteneur quadrangulaire (12, 42, 72) présente une structure de support interne avec des montants creux (54) et **en ce qu'**au moins certains des montants creux (54) forment, avec au moins une portion de leur espace interne respectif (56), une partie d'un circuit de refroidissement fermé (110) d'un système de refroidissement pour le conteneur (12, 42, 72).

10. Conteneur d'essai selon la revendication 9, **caractérisé en ce qu'**au fond du conteneur sont disposés (50) plusieurs montants creux (54) disposés de préférence parallèlement, lesquels sont prévus pour supporter la charge pondérale des composants (14, 16, 58, 90) disposés dans le conteneur (12, 42, 72) et sont connectés les uns aux autres par leurs espaces internes respectifs (56) par une technique d'écoulement en tant que partie du circuit de refroidissement fermé (110).

11. Conteneur d'essai selon l'une quelconque des revendications 9 ou 10, **caractérisé en ce qu'**un évaporateur (112) d'un système de refroidissement (110) pour le conteneur (12, 42, 72) est formé par au moins une partie des montants creux (54).

12. Conteneur d'essai selon l'une quelconque des revendications 9 à 11, **caractérisé en ce qu'**à l'intérieur (56) d'au moins un montant creux (54) est guidé un corps creux séparé en forme de tuyau ou de tube (36, 38, 126), par lequel est formée une portion du circuit de refroidissement fermé (110).

13. Système de laboratoire d'essai pour transformateurs de puissance, **caractérisé en ce que** celui-ci est construit sous forme modulaire et comprend au moins un conteneur d'essai selon l'une quelconque des revendications 1 à 12, avec des dispositifs d'essai pour transformateurs de puissance.

14. Système de laboratoire d'essai pour transformateurs de puissance selon la revendication 13, **caractérisé en ce qu'**un onduleur est formé à des fins d'essai par les composants électriques disposés dans au moins un conteneur quadrangulaire (12, 42, 72).
